Europäisches Patentamt

**European Patent Office**

Office européen des brevets

(11) Publication number: **0 077 622**
**A1**

# EUROPEAN PATENT APPLICATION

(21) Application number: **82305359.0**

(22) Date of filing: **08.10.82**

(51) Int. Cl.³: **B 23 K 35/362**
**//H05K3/10**

(30) Priority: **16.10.81 GB 8131316**

(43) Date of publication of application:
**27.04.83 Bulletin 83/17**

(84) Designated Contracting States:
**BE DE FR IT NL**

(71) Applicant: **Multicore Solders Limited**
**Maylands Avenue Hemel Hempstead**
**Hertfordshire HP2 7EP(GB)**

(72) Inventor: **Arbib, Gordon Francis**
**Kelsey House Wood Lane End**
**Hemel Hempstead Hertfordshire, HP2 4RF(GB)**

(72) Inventor: **Rubin, Wallace**
**Kelsey House Wood Lane End**
**Hemel Hempstead Hertfordshire, HP2 4RF(GB)**

(72) Inventor: **Hedges, Philip**
**23 Selbourne Road**
**Luton Bedfordshire(GB)**

(74) Representative: Kosmin, Gerald Emmanuel et al,
**HASELTINE, LAKE & CO. Hazlitt House 28 Southampton**
**Buildings Chancery Lane**
**London, WC2A 1AT(GB)**

(54) Liquid fluxes for use in soldering.

(57) A liquid soldering flux for use in soft soldering in, for instance, the mass production of printed circuit assemblies and which will yield water-insoluble non-corrosive residues after soldering is formed by dissolving in an aqueous solvent a flux material having at least one carboxylic acid group therein, for example rosin, together with a volatile amine capable of forming an amine salt with the flux material and having a boiling point below the soldering temperature, the aqueous solvent containing a minor proportion of an organic solvent. This liquid flux avoids the hazards and expensive wastage inherent in the known organic solvent-based liquid fluxes, and also avoids the removal by washing of the relatively corrosive residues obtained after soldering with the known water-based fluxes.

Croydon Printing Company Ltd.

- 1 -

## LIQUID FLUXES FOR USE IN SOLDERING

This invention relates to liquid fluxes for use in soldering and is concerned with a non-corrosive liquid soldering flux suitable for use in the electronics industry, for example in the mass production of printed circuit assemblies.

Rosin-based liquid fluxes are generally used in the automatic soldering of electronic components to printed circuit boards employed, for example, in the electronics industry. The liquid fluxes can be applied to the underside of a printed circuit board on which lie the lead wires of the electronic components mounted on the top side of the board, the application being by means of spraying, a standing wave, or a foam generated by the passage of air through the liquid flux. Such liquid fluxes normally fall into two types. In the first type, the flux material, normally rosin (colophony), is dissolved in a volatile organic solvent, for example isopropanol, and the solvent content of the liquid flux is commonly as high as 80% w/w. After application to a printed circuit board, for example in the form of a foam, it is normally necessary to dry off the applied liquid flux, for example with the aid of hot air or infra-red heating, before a molten solder is applied to the fluxed printed circuit board. After soldering, non-corrosive substantially water-insoluble residues remain at the soldered joints and such residues need not normally be removed. This type of liquid flux has several disadvantages. Firstly, the organic solvent used is usually a flammable solvent having a relatively low flashpoint, such as 12$^{\circ}$C (53$^{\circ}$F), which gives rise to potential fire and toxicity hazards during storage and use and also in transportation especially by air cargo and post. Dangerous hot vapours are emitted during the drying stage, between flux application and soldering, which are potentially explosive. Secondly, since the solvent evaporates during use there is expensive wastage and a necessity to top up the liquid flux tank adjacent to the soldering machine. In addition it is necessary for the operator to constantly inspect and adjust the specific gravity of the liquid flux.

More recently, with a view to overcoming the aforementioned disadvantages, a second type of rosin-based liquid flux has come into use. In this type, the flux material employed is water-soluble, for example a rosin soap, so that the solvent employed can be water-based. This obviates the disadvantages of using a volatile organic solvent, but since the residues obtained after soldering are not as non-corrosive as water-insoluble residues, it is necessary completely to remove them by a careful washing process which must be rigorously monitored to ensure that the residues have been removed.

It is an object of the present invention to provide a liquid soldering flux which will substantially avoid the disadvantages of the known organic solvent-based liquid fluxes but which will in use form substantially non-corrosive water-insoluble residues and thereby avoid the disadvantages of the water-soluble liquid fluxes.

We have found that a non-corrosive liquid flux yielding substantially water-insoluble non-corrosive residues after soldering can be formed from an aqueous solvent containing a minor proportion of organic solvent if the rosin-based flux material has incorporated therewith a volatile amine which is capable of forming an amine salt with the flux material but which is capable of evaporating at the soldering temperature employed in a soldering process.

Thus in accordance with the invention there is provided a liquid soldering flux comprising a flux material having at least one carboxylic acid group (COOH) therein in association with a volatile amine capable of forming an amine salt with the flux material and having a boiling point below the soldering temperature, the flux material and volatile amine being dissolved in an aqueous solvent comprising a major proportion of water and a minor proportion of an organic solvent.

The amine will generally be present in an amount which is the molar equivalent to the acidity of the flux material. This amount may vary within the range from 8 to 45% by weight, based on the weight of the flux material present in the liquid soldering flux, according to the amine employed.

To prepare the liquid soldering flux of the invention, the flux material and amine may be dissolved in the organic solvent and the resulting solution may then be diluted with the water, which is the major constituent of the aqueous solvent employed, to form a clear solution.

The liquid soldering flux prepared in this manner can be used in a manner similar to the known organic solvent-based liquid fluxes, subject to the use of a somewhat higher drying off temperature to ensure the removal of the water by evaporation prior to soldering so as to prevent excessive spitting or spattering due to the boiling of the water at the soldering temperature.

The flux material employed in the liquid soldering flux of the invention may be any suitable non-corrosive flux material containing a carboxyl group, for example rosin (abietic acid) which may or may not be activated, hydrogenated rosin (e.g. the commercially available Staybelite resin sold by Hercules Limited), or a maleic modified rosin (e.g. the commercially available Pentalyn M600 also sold by Hercules Limited).

The volatile amine is preferably an alkanolamine, for example ethanolamine, or a cyclic amine derivable therefrom, for example morpholine. Other volatile amines which may be employed are primary, secondary or tertiary alkylamines such as, for example, methylamine, ethylamine, n-propylamine, isopropylamine, n-butylamine, n-amylamine, n-hexylamine, n-heptylamine, n-octylamine, n-nonylamine, n-decylamine, dimethylamine, diethylamine, dipropylamine, dibutylamine, diamylamine, trimethylamine,

- 4 -

triethylamine and tripropylamine.

The organic solvent component of the aqueous solvent may be a primary alcohol, for example isopropanol, or secondary alcohol, for example sec-butanol, or preferably a glycol, for example hexylene glycol (i.e. 2-methyl-pentane-2:4-diol). If desired there may be used a mixture of the primary or secondary alcohol and the glycol, for example a mixture of isopropanol or sec-butanol and hexylene glycol. Such mixtures may be advantageous where the liquid flux is to be applied in the form of a foam.

The proportion of organic solvent in the aqueous solvent may range from 5 - 30% w/w.

Where the liquid soldering flux is to be used in the form of a foam, it is generally advantageous to incorporate in the flux an anti-foaming agent, for example a water-soluble silane, to prevent excessive formation of foam and ensure that there is sufficient break up of the foam after application.

For a better understanding of the invention and to show how the same can be carried into effect, the following illustrative Examples will now be given.

EXAMPLE 1

28 grams of a solid non-corrosive amine hydrochloride-activated rosin flux (the commercially available product ERSIN 366) and 5.5 grams of ethanolamine were dissolved in 17 grams of isopropanol and the resulting solution was diluted with 160 grams of water to form a clear solution at ambient temperature (20°C). The liquid soldering flux formed in this manner had a flashpoint of 36°C (97°F).

When used as the liquid flux in an automatic soldering apparatus for the mass-production of printed circuit assemblies, the foregoing liquid soldering flux formed non-corrosive water-insoluble residues.

EXAMPLE 2

The procedure described in Example 1 was repeated with the following materials:

- 5 -

| | |
|---|---|
| ERSIN 366 | 30.0 g |
| Ethanolamine | 5.9 g |
| Sec-butanol | 14.0 g |
| Water | 155.0 g |

The resulting liquid soldering flux, which was a clear solution at ambient temperature, had a flashpoint of 41$^{\circ}$C (106$^{\circ}$F) and produced non-corrosive water-insoluble residues when used in the automatic production of printed circuit assemblies.

EXAMPLE 3

The procedure described in Example 1 was repeated with the following materials:

| | |
|---|---|
| ERSIN 366 | 30.0 g |
| Ethanolamine | 5.9 g |
| Hexylene glycol | 30.0 g |
| Water | 140.0 g |

The resulting liquid soldering flux, which was a clear solution at ambient temperature, was non-flammable and produced non-corrosive water-insoluble residues when used in the mass-production of printed circuit assemblies.

EXAMPLE 4

The procedure described in Example 1 was repeated with the following materials:

| | |
|---|---|
| ERSIN 366 | 30.0 g |
| Morpholine | 8.4 g |
| Hexylene glycol | 30.0 g |
| Water | 140.0 g |

The resulting liquid soldering flux, which was a clear solution at ambient temperature, was non-flammable and produced non-corrosive water-insoluble residues when used in the mass-production of printed circuit assemblies.

EXAMPLE 5

The procedure described in Example 1 was repeated with the following materials:

| | |
|---|---|
| ERSIN 362 | 30.0 g |
| Ethanolamine | 5.9 g |
| Hexylene glycol | 30.0 g |
| Water | 140.0 g |

Ersin 362 is a commercially available solid non-corrosive amine hydrochloride-activated rosin flux. The resulting liquid soldering flux, which was a clear solution at ambient temperature, was non-flammable and produced non-corrosive water-insoluble residues when used in the mass-production of printed circuit assemblies.

## EXAMPLE 6

The procedure described in Example 1 was repeated with the following materials:

| | |
|---|---|
| Non-activated rosin flux | 30.0 g |
| Morpholine | 8.4 g |
| Hexylene glycol | 30.0 g |
| Water | 140.0 g |

The resulting liquid soldering flux, which was a clear solution at ambient temperature, was non-flammable and produced non-corrosive water-insoluble residues when used in the mass-production of printed circuit assemblies.

## EXAMPLE 7

A liquid soldering flux was prepared from the following materials:

| | |
|---|---|
| ERSIN 366 | 30.0 g |
| Ethanolamine | 5.9 g |
| Hexylene glycol | 27.0 g |
| Isopropanol | 3.0 g |
| Water | 140.0 g |
| Anti-foaming agent (Dow 544) | 0.002 g |

Dow 544 is a water soluble silane which acts as an anti-foaming agent and was used as a 1% by weight solution in isopropanol, 0.2 ml. of this solution being admixed with the other flux ingredients.

The liquid soldering flux obtained was used in the mass-production of printed circuit assemblies, the flux being applied in the form of a foam produced by passing air in the form of small bubbles into a reservoir of the liquid soldering flux. The presence of the anti-foaming agent ensures that the foam maintains a stable height

0077622

- 7 -

and breaks sufficiently quickly on the underside of the printed circuit board to which the foam has been applied so as not to be carried over to the next processing stage, normally the pre-heat station.

CLAIMS:

1.  A non-corrosive liquid soldering flux capable of yielding substantially water-insoluble non-corrosive residues after use in a soldering process, the flux comprising a flux material having at least one free carboxyl group in association with a volatile amine capable of forming an amine salt with the flux material and having a boiling point below the soldering temperature, the flux material and volatile amine being dissolved in an aqueous solvent comprising a major proportion of water and a minor proportion of an organic solvent.

2.  A liquid flux as claimed in Claim 1, wherein the volatile amine is present in an amount of from 8 to 45% by weight, based on the weight of said flux material.

3.  A liquid flux as claimed in Claim 1 or 2, wherein the aqueous solvent contains from 5 to 30% by weight of said organic solvent.

4.  A liquid flux as claimed in Claim 1, 2 or 3, wherein the flux material is an activated or non-activated rosin.

5.  A liquid flux as claimed in Claim 1, 2, 3 or 4, wherein the volatile amine is an alkanolamine, or a cyclic amine derivable from said alkanolamine.

6.  A liquid flux as claimed in Claim 5, wherein the amine is ethanolamine or morpholine.

7.  A liquid flux as claimed in any preceding claim, wherein said organic solvent is a primary alcohol, a secondary alcohol or a glycol, or a mixture of the alcohol and glycol.

8.  A liquid flux as claimed in Claim 7, wherein the organic solvent is isopropanol, sec-butanol or hexylene glycol, or a mixture of hexylene glycol and isopropanol or sec-butanol.

9.      A liquid flux as claimed in any preceding claim, wherein an anti-foaming agent is incorporated therein.

## DOCUMENTS CONSIDERED TO BE RELEVANT

EP 82305359.0

| Category | Citation of document with indication, where appropriate, of relevant passages | Relevant to claim | CLASSIFICATION OF THE APPLICATION (Int. Cl. ³) |
|---|---|---|---|
| X | WO - A1 - 80/02 663 (WINCHESTER ELECTRONICS GMBH) <br> * Totality, especially claim 1 * | 1-8 | B 23 K 35/362// <br> H 05 K 3/10 |
| A | DE - A - 1 483 474 (OHARA, MITSUTARO) <br> * Page 6, lines 18-30; claim 14 * | 1,4-7 | |
| A | US - A - 4 168 996 (F.M. ZADO) <br> * Totality, especially column 5, line 24 - column 8, line 35; claims * | 1-9 | |
| A | US - A - 4 194 931 (F.M. ZADO) <br> * Totality, especially column 2, lines 34-68; column 5, line 24 - column 8, line 35; claims * | 1-9 | TECHNICAL FIELDS SEARCHED (Int. Cl. ³) <br><br> B 23 K |

The present search report has been drawn up for all claims

| Place of search | Date of completion of the search | Examiner |
|---|---|---|
| VIENNA | 09-12-1982 | SLAMA |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82